# EUROPÄISCHE PATENTANMELDUNG

(11) **EP 1 296 498 A1**
(43) Veröffentlichungstag der Anmeldung: **26.03.2003**
(21) Anmeldenummer: 01122498.7
(22) Anmeldetag: 20.09.2001
(51) Int. Cl.: H04M 1/00, H03G 3/32

(54) **Verfahren und Vorrichtung zum umgebungsabhängigen Regeln des Betriebs eines mobilen Kommunikationsgerätes**

(71) Anmelder: SIEMENS AKTIENGESELLSCHAFT, 80333 München (DE)
(72) Erfinder: Poerschmann, Christoph, 45966 Gladbeck (DE)

(57) **Zusammenfassung**

Bei einem Verfahren zum Regeln des Betriebs eines Signale aussendenden Gerätes, abhängig von den in der Umgebung des Gerätes herrschenden Bedingungen, wird die Aufgabe, das Verfahren zu Automatisieren, gelöst durch
a) Erfassen der Größe eines Meßwertes mindestens einer Meßgröße, die für eine durch den Betrieb des Gerätes beeinflußte Eigenschaft der Umgebung des Gerätes repräsentativ ist, und
b) Anpassen der Intensität der Signale des Gerätes zur verminderten Beeinflussung der Eigenschaft der Umgebung aufgrund der Größe des Meßwertes gelöst. Die Erfindung betrifft außerdem ein Gerät zur Durchführung des Verfahrens, insbesondere ein mobiles Kommunikationsendgerät.

## Beschreibung

Die Erfindung bezieht sich auf ein Verfahren zum Regeln des Betriebs eines Signale aussendenden Gerätes, abhängig von den in der Umgebung des Gerätes herrschenden Bedingungen, und auf ein Gerät zur Durchführung des Verfahrens.

Ein solches Verfahren wird beispielsweise durchgeführt, um die Intensität akustischer Signale von mobilen Kommunikationsendgeräten, wie Klingeltönen oder Sprachsignalen, an Umgebungsbedingungen anzupassen. In dem Fall, dass in der Umgebung des Kommunikationsendgerätes die Bedingung herrscht, dass Personen von Klingeltönen eines Kommunikationsendgerätes nicht gestört werden sollen, regelt bisher der Benutzer des Kommunikationsendgerätes die Klingeltöne auf eine geringe Intensität oder schaltet das Kommunikationsendgerät aus. Bei dem bekannten Verfahren handelt es sich somit um eine manuelle Methode, die insofern als nachteilig anzusehen ist, dass sie grundsätzlich eine Einflußnahme des Benutzers des Kommunikationsendgerätes auf den Betrieb des Kommunikationsendgerätes erfordert.

Außerdem ist auch ein manuelles Verfahren zum Abschalten von mobilen Datenverarbeitungsgeräten, wie Palmtops und Notebooks, bekannt, daß insbesondere vor dem Start und vor der Landung eines Flugzeuges durchgeführt wird. In beiden Fällen erfolgt eine Aufforderung an Benutzer solcher Geräte, diese abzuschalten, um das Aussenden elektrischer Störsignale zu vermeiden.

Ausgehend hiervon liegt der Erfindung die Aufgabe zu Grunde, ein Verfahren zu schaffen, dass eine automatische Anpassung des Betriebs eines Signale aussendenden Gerätes an die am Ort des Gerätes herrschenden Umgebungsbedingungen gestattet. Es soll auch ein Gerät bereitgestellt werden, dass zur Durchführung des Verfahrens geeignet ist.

Die Aufgabe wird hinsichtlich des Verfahrens gelöst durch ein Verfahren zum Regeln des Betriebs eines Signale, wie akustische oder elektrische Signale, aussendenden Gerätes, abhängig von den in der Umgebung des Gerätes herrschenden Bedingungen, mit den Schritten:
a) Erfassen der Größe eines Meßwertes mindestens einer Meßgröße, die für eine durch die Signale des Gerätes beeinflußte Eigenschaft der Umgebung des Gerätes repräsentativ ist, und
b) Anpassen des Intensität der Signale des Gerätes zur verminderten Beeinflussung der Eigenschaft der Umgebung aufgrund der Größe des Meßwertes.

Eine mögliche Eigenschaft der Umgebung eines mobilen Kommunikationsgerätes als Signale aussendendes Gerät ist beispielsweise, daß sie gegenüber akustischen Störungen, die durch Klingeltöne des Kommunikationsgerätes hervorgerufen werden, zu schützen ist. In diesem Fall ist bevorzugt in Schritt a) die Meßgröße so gewählt, daß sie für die Eigenschaft der Umgebung, daß akustische Signale des Kommunikationsgerätes unerwünscht sind, repräsentativ ist, und in Schritt b) wird die Intensität der akustischen Signale des mobilen Kommunikationsgerätes auf ein angemessenes Maß eingestellt. So können beispielsweise die Intensität von Klingeltönen oder Sprachsignalen des Kommunikationsgerätes, abhängig von dem Meßwert der Meßgröße von einer Grundeinstellung aus vermindert werden oder das Kommunikationsgerät kann automatisch abgeschaltet werden. Es ist ebenfalls möglich, daß, wenn anhand der Meßgröße festgestellt wird, das akustische Störungen unbeteiligter Personen unerwünscht sind, die Alarmierung eines Benutzers des Kommunikationsgerätes nicht per Klingelton, sondern durch nicht akustische Mittel vorgenommen wird, wie beispielsweise einen Vibrationsalarm.

Im Hinblick auf den Schutz unbeteiligter Personen vor störenden Klingeltönen des Gerätes ist in Schritt a) die Meßgröße bevorzugt aus der Gruppe ausgewählt, die das Erdmagnetfeld, im Falle eines mobilen Kommunikationsendgerätes ein GSM-Signal einer Netzwerk-Basisstation des Kommunikationsgerätes, eine Helligkeit am Ort des Gerätes, die Art des am Ort des Gerätes vorherrschenden Lichts, beispielsweise künstliches Licht, und die Umgebungslautstärke am Ort des Gerätes umfaßt.

Beispielsweise zeigt eine vergleichsweise geringe Intensität des Erdmagnetfelds an, daß der Benutzer z. B. eines Kommunikationsendgerätes sich in einem geschlossenen Raum befinden kann. Innerhalb massiver Gebäude, wie beispielsweise einer Kirche, wird das GSM-Signal der Netzwerk-Basisstation des Kommunikationsgerätes geschwächt an das Kommunikationsgerät übermittelt. Dies kann ausgenutzt werden um festzustellen, ob sich das Kommunikationsgerät in einer Umgebung befindet, die gegen akustische Störungen zu schützen ist.

Auch die Unterscheidung zwischen natürlichem und künstlichem Licht kann benutzt werden, um zwischen schützenswerten und nicht schützenswerten Umgebungen des Kommunikationsgerätes zu differenzieren. In diesem Zusammenhang ist es bevorzugt, daß das Kommunikationsgerät eine Einrichtung zur Erfassung der Wechselfrequenz künstlicher Leuchtmittel aufweist, die bei Leuchtmitteln, die mit der Netzfrequenz von 50 Hz betrieben werden, 100 Hz beträgt. Allgemeiner ausgedrückt, kann das mobile Kommunikationsgerät mit einer Erfassungseinrichtung für nicht-natürliches Licht ausgestattet werden.

Auch die Umgebungslautstärke kann als Meßgröße eingesetzt werden, denn ein hoher Wert für die Umgebungslautstärke zeigt im Regelfall an, daß kein besonderer Bedarf an Schutz von Personen gegenüber akustischen Signalen von Kommunikationsgeräten besteht.

Allgemein kann die Erfassung der Meßgröße unmittelbar im Kommunikationsgerät stattfinden oder ein Meßwert wird extern erfaßt und einer Empfangseinrichtung des Kommunikationsgerätes zugeleitet.

Alternativ können in Schritt a) dem Gerät auch externe Signale als Meßgröße zugeführt werden, die für die in der Umgebung des Gerätes herrschenden Bedingungen repräsentativ sind. Im Falle eines Schutzes von Personen gegenüber akustischen Störungen durch Kommunikationsgeräte können die externen Signale, die von dem Kommunikationsgerät empfangen werden, beispielsweise eine Verminderung der Intensität der Klingeltöne, ein Abschalten des Kommunikationsgerätes oder eine Umstellung des Alarms von Klingeltonalarm auf Vibrationsalarm hervorrufen.

Es ist beispielsweise denkbar, daß Veranstaltungsräume, wie Theater und Kinos, oder Personenbeförderungsfahrzeuge, wie Busse oder Flugzeuge, mit einer Senderanordnung ausgestattet werden, die beispielsweise den Eingängen der Räume bzw. der Fahrzeuge zugeordnet ist und die externe Signale aussendet. Die Sender und ein Kommunikationsgerät können auch über ein Protokoll miteinander kommunizieren. Die externen Signale sind beispielsweise Infrarotsignale, in welchem Fall das mobile Kommunikationsgerät mit einer Infrarotschnittstelle zum Empfang der Infrarotsignale auszustatten ist. Alternativ ist auch der Einsatz von Funksignalen möglich.

Sofern beabsichtigt ist, mobile Endgeräte, wie Palmtops oder Notebooks, beispielsweise vor dem Start oder der Landung eines Flugzeuges automatisch abzuschalten, sind diese Geräte mit einem Detektor ausgestattet, der die von einem Sender ausgestrahlten Steuersignale, wie Infrarotsignale oder Funksignale, zum Abschalten der Geräte umsetzt.

Die oben genannte Aufgabe wird hinsichtlich des Gerätes gelöst durch ein Gerät, das Signale aussendet, wobei das Gerät eine Detektoranordnung zum Erfassen der Größe eines Meßwertes mindestens einer Meßgröße, die für eine durch die Signale des Gerätes beeinflußte Eigenschaft der Umgebung des Gerätes repräsentativ ist, und
eine Regeleinrichtung, der der Meßwert zugeleitet wird, zum Anpassen der Intensität der Signale des Gerätes zur verminderten Beeinflussung der Eigenschaft der Umgebung aufgrund der Größe des Meßwertes aufweist.

Die Detektoranordnung kann einen oder mehrere Detektoren umfassen, um eine oder mehrere Meßgrößen der genannten Art zu erfassen.

Beispielsweise kann die Detektoranordnung einen Detektor zur Messung der Größe des Erdmagnetfelds als Meßgröße aufweisen. Zu diesem Zweck kann das Gerät mit einem Magnetfeldmesser ausgestattet sein, dessen Ausgangssignale der Regeleinrichtung zugeführt werden.

Gegebenenfalls weist die Detektoranordnung einen Detektor zum Messen der Empfangspegelstärke eines GSM-Signals einer Basisstation eines Kommunikationsendgerätes als Signale aussendendes Gerät auf. Die meisten derzeit im Handel erhältlichen Mobiltelefone, die Geräte, insbesondere Kommunikationsendgeräte, im Sinne dieser Erfindung sind, sind bereits mit einer Meßeinrichtung zum Messen dieser Empfangspegelstärke ausgestattet. Das Ausgangssignal dieser Meßeinrichtung ist der Regeleinrichtung zum Anpassen des Betriebs des Kommunikationsendgerätes, beispielsweise der Intensität seiner Klingeltöne, zuzuführen.

Bei einem weiteren Ausführungsbeispiel weist die Detektoranordnung eine Helligkeitsdetektor zum Messen der Größe der Helligkeit in der Umgebung des Gerätes auf. Ein gebräuchlicher Helligkeitsdetektor ist eine Fotodiode, mit der das Kommunikationsendgerät ausgestattet werden kann.

Eine Fotodiode kann auch als Detektor zum Feststellen von künstlichem Licht benutzt werden, denn mit ihrer Hilfe kann festgestellt werden, ob die für künstliche Leuchtmittel typische Wechselfrequenz von 100 Hz vorliegt.

Als Detektor für die Messung der Umgebungslautstärke kann ein Mikrofon eingesetzt werden.

Zur Steuerung durch externe Signale kann die Detektoranordnung einen Detektor zur Erfassung äußerer Signale aufweisen, die beispielsweise zum Ausschalten eines Endgerätes, wie eines Palmtop oder Notebook, umgesetzt werden. Die Steuersignale können beispielsweise Funk- oder Infrarotsignale sein.

Die von den jeweiligen Detektoren aufgenommenen Meßwerte können in regelmäßigen Zeitabständen oder kontinuierlich erfaßt werden. Der Verlauf der Meßwerte in der Zeit kann benutzt werden, um den Betrieb des Kommunikationsendgerätes zu steuern. Beispielsweise können die Klingeltöne eines Mobiltelefons beim Betreten eines Theaters abgeschaltet und es kann auf Vibrationsalarm umgeschaltet werden. Beim Verlassen des Theaters wird der Alarm zurück auf Klingeltonalarm umgestellt. Dies kann durch Überwachung beispielsweise des Meßwerts für das GSM-Signal einer Netzwerk-Basisstation des Kommunikationsendgerätes bewerkstelligt werden.

Die Erfindung wird nachfolgend anhand von Ausführungsbeispielen unter Bezugnahme auf die Zeichnungen noch näher beschrieben. Es zeigen:
Fig. 1 Ein Blockschaltbild eines die Ausgabe von Klingeltönen betreffenden Teils eines mobilen Kommunikationsendgerätes als Signale aussendendes Gerät und
Fig. 2 Eine schematische Ansicht einer Ausführungsform der Erfindung, bei der ein mobiles Kommunikationsendgerät als Signale aussendendes Gerät durch externe Signale hinsichtlich seiner Klingeltonausgabe gesteuert wird.

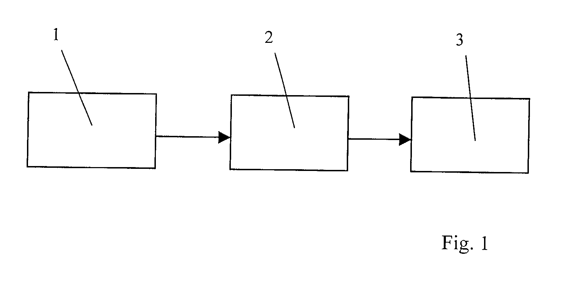

Wie aus Fig. 1 hervorgeht, umfaßt der Grundaufbau einer Einrichtung zum Steuern der Klingeltonintensität eines Mobiltelefons eine Detektoranordnung 1, die einen Meßwert erfaßt, der geeignet ist anzuzeigen, ob sich das Kommunikationsendgerät in einer gegenüber akustischen Störungen zu schützenden Umgebung befindet.

Der erfaßte Meßwert wird zur Weiterverarbeitung einer Regeleinrichtung 2 zugeführt, die den Meßwert für die relevante Meßgröße, beispielsweise das GSM-Signal der Basisstation des Kommunikationsendgerätes, zu einem Referenzwert in Beziehung setzt, der beispielsweise der mittleren Signalintensität des GSM-Signals entspricht. Wird der Referenzwert um ein vorgestimmtes Maß unterschritten, bewirkt die Regeleinrichtung 2, daß Klingeltöne, die von einem Klingeltongenerator 3 erzeugt werden, unterdrückt werden. Eingehende Rufe für das Kommunikationsendgerät können dann mittels eines Vibrationsalarms einem Benutzer des Kommunikationsendgerätes angezeigt werden.

Die Detektoranordnung 1 kann einen oder mehrere Detektoren aufweisen.

In einem Ausführungsbeispiel umfaßt die Detektoranordnung 1 sowohl eine Detektor für die Intensität des GSM-Signals als auch einen Detektor in Form einer Fotodiode zur Erfassung der Helligkeit in der Umgebung des Kommunikationsendgerätes. Die beiden Meßgrößen GSM-Signalintensität und Helligkeit verringern sich signifikant, wenn der Benutzer des Kommunikationsendgerätes beispielsweise eine Kirche betritt, bei der eine Störung unbeteiligter Personen vor Klingelsignalen des Kommunikationsendgerätes auszuschließen ist. In diesem Fall bewirkt die Regeleinrichtung 2 das Ausschalten des Klingeltongenerators 3. Zusätzlich kann dem Benutzer des Kommunikationsendgerätes durch eine kurzzeitige Aktivierung eines Vibrationsalarms angezeigt werden, daß das mobile Kommunikationsendgerät nunmehr von hörbaren Klingeltönen auf Vibrationsalarm umgeschaltet ist. Die Meßwerte für Helligkeit und GSM-Signalintensität können fortlaufend erfaßt werden, so daß beim Verlassen der Kirche das Kommunikationsendgerät wieder auf Klingeltonalarm umgeschaltet wird.

Alternativ ist es auch möglich, daß die Regeleinrichtung 2 lediglich die Intensität der Klingeltöne an die jeweiligen Umgebungsbedingungen anpaßt, jedoch den Klingeltongenerator 3 nicht vollständig ausschaltet.

In weiteren Ausführungsbeispielen kann die Detektoranordnung 1 auch einen Magnetfeldmesser zur Erfassung eines Meßwertes für das Erdmagnetfeld und/oder eine Fotodiode zum Feststellen, ob in der Umgebung des Kommunikationsendgerätes künstliches Licht vorliegt und einen Detektor für die Umgebungslautstärke, beispielsweise ein Mikrofon, aufweisen. Die beschriebenen Detektoren können jeweils allein oder in Kombination miteinander in einem Kommunikationsendgerät enthalten sein.

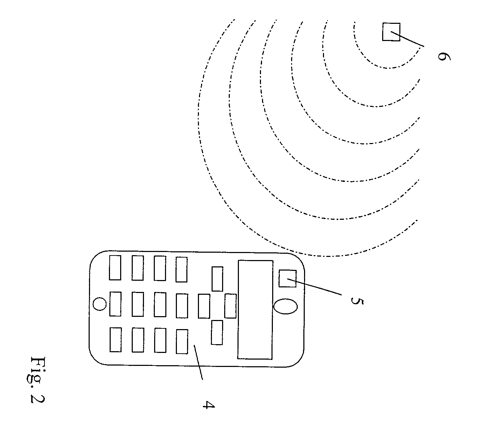

Die Fig. 2 zeigt eine alternative Ausführungsform der Erfindung, bei der ein mobiles Kommunikationsendgerät 4 mit einem Empfänger 5 für Infrarotsignale ausgestattet ist. Ein Sender 6 sendet die Infrarotsignale aus, die von dem Empfänger 5 empfangen und von dem mobilen Kommunikationsendgerät 4 weiterverarbeitet werden.

Die von dem Empfänger 4 erfaßten externen Infrarotsignale steuern die Klingeltonausgabe des mobilen Kommunikationsendgerätes 4. Beispielsweise kann ein Empfang der Infrarotsignale bewirken, daß ein Klingeltongenerator des mobilen Kommunikationsendgerätes 4 ausgeschaltet und daß auf einen Vibrationsalarm umgeschaltet wird.

In praktischen Anwendungen kann der Sender 6 in Eingangsbereichen von Räumen, in denen Klingeltonsignale eines mobilen Kommunikationsendgerätes unerwünscht sind, angeordnet sein, so daß, wenn der Benutzer des Kommunikationsendgerätes 3 einen solchen Raum betritt, der Empfänger 5 in die Reichweite des Senders 6 gelangt, wonach die empfangenen Infratorsignale, wie oben geschrieben, in dem mobilen Kommunikationsendgerät 4 weiterverarbeitet werden.

Hervorzuheben ist eine Anwendung der Ausführungsform der Erfindung nach Fig. 2 bei Flugzeugen, bei denen beispielsweise vor dem Starten des Flugzeugs mobile Kommunikationsendgeräte abzuschalten sind. Dies ist jedoch im Einzelfall schwer zu überprüfen. Wenn der Sender 6 zum Erfassen der Eingangsbereiche des Flugzeugs angeordnet ist, wird es ermöglicht, sämtliche Kommunikationsendgeräte von Benutzern, die gerade das Flugzeug betreten, zentral auszuschalten und somit das Risiko einer Gefährdung der Flugsicherheit durch die mobilen Kommunikationsendgeräte zu vermeiden.

## Patentansprüche

1. Verfahren zum Regeln des Betriebs eines Signale, wie akustische oder elektrische Signale, aussendenden Gerätes, abhängig von den in der Umgebung des Gerätes herrschenden Bedingungen, mit den Schritten:
a) Erfassen der Größe eines Meßwertes mindestens einer Meßgröße, die für eine durch die Signale des Gerätes beeinflußte Eigenschaft der Umgebung des Gerätes repräsentativ ist, und
b) Anpassen der Intensität der Signale des Gerätes zur verminderten Beeinflussung der Eigenschaft der Umgebung aufgrund der Größe des Meßwertes.

2. Verfahren nach Anspruch 1,
bei dem in Schritt a) die Meßgröße so gewählt wird, daß sie für die Eigenschaft der Umgebung, daß akustische Signale des Geräts unerwünscht sind, repräsentativ ist, und in Schritt b) die Intensität der akustischen Signale des Gerätes auf ein angemessenes Maß eingestellt wird.

3. Verfahren nach Anspruch 2,
bei dem in Schritt a) die Meßgröße aus der Gruppe ausgewählt ist, die das Erdmagnetfeld, eine Helligkeit am Ort des Gerätes, die Art des am Ort des Gerätes vorherrschenden Lichtes und die Umgebungslautstärke am Ort des Gerätes umfaßt.

4. Verfahren nach Anspruch 1,
bei dem in Schritt a) dem Gerät externe Signale als Meßgröße zugeführt werden, die für die in der Umgebung des Gerätes herrschenden Bedingungen repräsentativ sind.

5. Verfahren nach Anspruch 4,
bei dem die externen Signale Infrarotsignale sind und das Gerät mit einer Infrarotschnittstelle zum Empfang der Infrarotsignale ausgestattet wird.

6. Gerät, das Signale, wie akustische oder elektrische Signale, aussendet,
**dadurch gekennzeichnet, daß**
das Gerät eine Detektoranordnung (1) zum Erfassen der Größe eines Meßwertes mindestens einer Meßgröße, die für eine durch die Signale des Gerätes beeinflußte Eigenschaft der Umgebung des Gerätes repräsentativ ist, und
eine Regeleinrichtung (2), der der Meßwert zugeleitet wird, zum Anpassen der Intensität der Signale des Gerätes zur verminderten Beeinflussung der Eigenschaft der Umgebung aufgrund der Größe des Meßwertes aufweist.

7. Gerät nach Anspruch 6,
**dadurch gekennzeichnet, daß**
die Detektoranordnung (1) zum Erfassen einer Meßgröße ausgebildet ist, die für die Eigenschaft der Umgebung, dass akustische Signale des Gerätes unerwünscht sind, repräsentativ ist.

8. Gerät nach Anspruch 6 oder 7,
**dadurch gekennzeichnet, daß**
die Detektoranordnung (1) einen Detektor zur Messung der Größe des Erdmagnetfelds als Meßgröße aufweist.

9. Gerät nach einem der Ansprüche 6 bis 8,
**dadurch gekennzeichnet, daß**
das Gerät ein mit einem Netzwerk verbundenes mobiles Kommunikationsendgerät (4) ist und die Detektoranordnung (1) einen Detektor zum Messen der Empfangspegelstärke eines GSM-Signals einer Basisstation des Kommunikationsendgerätes aufweist.

10. Gerät nach einem der Ansprüche 6 bis 9,
**dadurch gekennzeichnet, daß**
die Detektoranordnung (1) einen Helligkeitsdetektor zum Messen der Größe der Helligkeit in der Umgebung des Gerätes aufweist.

11. Gerät nach einem der Ansprüche 6 bis 10,
**dadurch gekennzeichnet, daß**
die Detektoranordnung (1) einen Detektor zum Feststellen von künstlichem Licht aufweist.

12. Gerät nach einem der Ansprüche 6 bis 11,
**dadurch gekennzeichnet, daß**
die Detektoranordnung (1) einen Detektor für die Messung der Umgebungslautstärke aufweist.

13. Gerät nach Anspruch 6,
**dadurch gekennzeichnet, daß**
die Detektoranordnung (1) einen Detektor zur Erfassung externer Signale als Meßgröße aufweist.
